(19) Europäisches Patentamt / European Patent Office / Office européen des brevets

(11) **EP 2 396 665 B1**

(12) **FASCICULE DE BREVET EUROPEEN**

(45) Date de publication et mention
de la délivrance du brevet:
**04.09.2019   Bulletin 2019/36**

(21) Numéro de dépôt: **10702685.8**

(22) Date de dépôt: **05.02.2010**

(51) Int Cl.:
**G01R 31/42** *(2006.01)*        **G01R 31/02** *(2006.01)*
**G01R 31/00** *(2006.01)*

(86) Numéro de dépôt international:
**PCT/EP2010/051414**

(87) Numéro de publication internationale:
**WO 2010/092007 (19.08.2010 Gazette 2010/33)**

(54) **PROCÉDÉ DE DÉTECTION D'UN COURT-CIRCUIT ET MODULE D'ALIMENTATION METTANT EN OEUVRE CE PROCÉDÉ**

VERFAHREN ZUM DETEKTIEREN EINES KURZSCHLUSSES UND STROMVERSORGUNGSMODUL ZUM DURCHFÜHREN DES VERFAHRENS

METHOD OF DETECTING A SHORT CIRCUIT AND POWER SUPPLY MODULE IMPLEMENTING SAME

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité:  **16.02.2009   FR 0900690**

(43) Date de publication de la demande:
**21.12.2011   Bulletin 2011/51**

(73) Titulaire: **Valeo Systèmes Thermiques
78321 Le Mesnil Saint Denis (FR)**

(72) Inventeurs:
• **CHAUVIN, Karen
F-78230 Le Pecq (FR)**
• **GATINOIS, Jean
F-78760 Jouars Pontchartrain (FR)**
• **VELA GARCIA, Ruben
F-78000 Versailles (FR)**

(74) Mandataire: **Metz, Gaëlle et al
Valeo Systèmes Thermiques
8, rue Louis Lormand
CS 80517 La Verrière
78322 Le Mesnil Saint Denis Cedex (FR)**

(56) Documents cités:
**EP-A- 1 519 465      DE-A1- 19 807 907
US-A- 5 428 967      US-A1- 2007 103 163**

## Description

La présente invention concerne un procédé de détection d'un court-circuit dans un module d'alimentation d'un équipement électrique, notamment à courant continu tel que divulgué dans le document US 2007/103163 A1. Elle concerne également un module d'alimentation apte à mettre en oeuvre un tel procédé.

L'invention trouve une application particulièrement avantageuse dans le domaine des circuits d'alimentation à courant continu d'équipements électriques de véhicules automobiles, notamment les moteurs de groupe moto-ventilateur apte à créer un flux d'air dans les installations de chauffage, ventilation et/ou climatisation.

Les installations de chauffage, ventilation et/ou climatisation des véhicules automobiles comportent généralement un groupe moto-ventilateur destiné à assurer un débit d'air dans l'habitacle du véhicule. Ce groupe moto-ventilateur comporte une turbine entraînée par un moteur électrique fonctionnant au moyen d'un courant fourni par un module d'alimentation.

En pratique, les modules d'alimentation utilisés dans cette application sont disposés entre une source d'alimentation, en particulier une batterie disposée dans le véhicule, et le moteur électrique à alimenter. Ils comportent une carte électronique sur laquelle sont implantés les composants nécessaires à l'alimentation du moteur électrique en courant d'alimentaiton à partir de la source d'alimentation, notamment la batterie du véhicule. En particulier, les modules d'alimentation peuvent comporter un interrupteur de courant, en particulier du type à modulation de largeur d'impulsion (également connue sous l'appellation anglophone 'PWM' pour "Pulse Width Modulation") L'interrupteur de courant de type PWM permet de faire varier le rapport cyclique d'impulsions de tension construites à partir de la tension de la source d'alimentation, donc de la batterie selon un exemple préférentiel.

Les modules d'alimentation comportent en outre un organe de dissipation de chaleur, tel qu'un radiateur, pour évacuer la chaleur produite par les composants, ainsi qu'un ou plusieurs connecteurs destinés à recevoir des faisceaux de conducteurs reliant respectivement le module d'alimentation à la batterie et au moteur électrique.

D'une manière générale, les composants électroniques présents dans de tels modules d'alimentation comprennent également un condensateur de filtrage d'entrée de forte capacité placé à l'entrée du module d'alimentation, en parallèle sur la batterie et le moteur électrique. En particulier, les condensateurs de filtrage les plus souvent utilisés sont des condensateurs chimiques dont les armatures présentent une polarité fixée.

Avec ce type de modules d'alimentation, il existe un risque de court-circuit entre les conducteurs des faisceaux reliés aux connecteurs pouvant notamment conduire à la mise en court-circuit du condensateur de filtrage d'entrée. Il résulte de cette situation de court-circuit que le courant délivré par la source d'alimentation augmente fortement avec pour conséquence un échauffement des conducteurs des faisceaux d'alimentation pouvant aller jusqu'à leur fusion.

D'autre part, la décharge du condensateur de filtrage peut produire des courants très élevés, de l'ordre de 200 A, dépassant largement les valeurs nominales de 30 A environ. Avec de tels courants, les composants du module d'alimentation s'échauffent, en particulier l'interrupteur de courant, par exemple de type PWM, et peuvent enflammer le matériau époxy constituant la carte électronique (également connue sous l'appellation anglophone 'PCB' pour "Printed Circuit Board").

Ce risque d'embrasement est d'autant plus grand, qu'en cas de court-circuit le radiateur de la carte électronique ne peut plus refroidir les composants qui s'y trouvent du fait que, le moteur électrique n'étant plus alimenté, il ne peut produire le flux d'air nécessaire au refroidissement du radiateur.

Il existe donc un besoin pour obtenir une détection précoce d'un court-circuit dans le module d'alimentation, de manière à ce que des mesures visant à en limiter les conséquences néfastes puissent être prises suffisamment tôt.

A cet effet, l'invention propose un procédé selon la revendication 1.

Ainsi, dès que le courant de décharge de le condensateur de filtrage d'entrée dépasse une valeur donnée, une situation de court-circuit est aussitôt diagnostiquée, entraînant la mise en oeuvre de moyens destinés, par exemple, à annuler le courant dans le circuit de décharge du condensateur de filtrage d'entrée, comme l'ouverture de l'interrupteur de courant, en particulier de type PWM.

L'invention prévoit que l'élément résistif est constitué par un composant de protection du condensateur de filtrage d'entrée contre une inversion de polarité du courant d'alimentation, par exemple un courant continu.

On sait en effet, et comme cela a été rappelé précédemment, que le condensateur de filtrage d'entrée du module d'alimentation est un condensateur chimique polarisé dont les armatures doivent être reliées aux bornes de polarité correspondante d'une source d'alimentation, notamment une batterie d'un véhicule automobile. En conséquence, une inversion de polarité de la source d'alimentation entraîne également une inversion de polarisation du condensateur de filtrage d'entrée et la destruction de ce dernier.

Selon une forme de réalisation particulière de l'invention, le composant de protection est un transistor de puissance MOSFET. Dans ce cas, la protection du condensateur de filtrage d'entrée est obtenue en appliquant à une grille du transistor de puissance MOSFET une tension grille-source $V_{gs}$ inférieure à un seuil de conduction dès qu'une inversion de la source d'alimentation est détectée, de sorte que le transistor de puissance MOSFET devienne non-conducteur et isole le condensateur de filtrage d'entrée de la source d'alimentation. En conditions normales d'utilisation, le transistor de puissance MOSFET est conducteur, la tension grille-source $V_{gs}$ étant alors supérieure au seuil de conduction.

La détection du court-circuit du condensateur de filtrage d'entrée est effectuée en mesurant une tension aux bornes de la résistance $R_{dsON}$ du transistor de puissance MOSFET, soit par un amplificateur de tension ou simplement au moyen d'un comparateur de tensions. Ces modes de réalisation peuvent être particulièrement avantageux si un comparateur ou un amplificateur non utilisé est déjà présent sur une carte électronique du module d'alimentation, notamment dans le cadre de l'emploi de boîtiers doubles ou quadruples comparateurs ou amplificateurs.

Une autre solution technique serait de placer un shunt de mesure de courant dans le circuit de décharge du condensateur de filtrage d'entrée, par exemple en série avec un interrupteur de courant, notamment de type PWM. Cependant, cette solution est moins avantageuse que celle faisant appel à un transistor de puissance MOSFET comme élément de protection car elle utilise un composant supplémentaire, coûteux, encombrant et dissipateur de chaleur. L'invention concerne également un module d'alimentation d'un équipement électrique, notamment à courant continu selon la revendication 3.

Selon l'invention, les moyens de détection comprennent un élément résistif disposé sur le circuit de décharge du condensateur de filtrage d'entrée, et des moyens de mesure d'une tension aux bornes de l'élément résistif.

Selon divers modes de réalisation, les moyens de mesure de la tension comprennent un amplificateur de tension et/ou un comparateur de tensions.

L'invention prévoit que l'élément résistif est constitué par un composant de protection du condensateur de filtrage d'entrée contre une inversion de polarité du courant d'alimentation, notamment du courant continu.

De façon préférentielle, le composant de protection est un transistor de puissance MOSFET.

La description qui va suivre en regard des dessins annexés, donnés à titre d'exemples non limitatifs, fera bien comprendre en quoi consiste l'invention et comment elle peut être réalisée, dessins sur lesquels :

• La figure 1 est un schéma d'un module d'alimentation d'un équipement électrique mettant en oeuvre le procédé de détection de court-circuit conforme à l'invention, et
• La figure 2 représente en (a) un diagramme des tensions appliquées au comparateur du module d'alimentation de la figure 1, et en (b) un diagramme correspondant du signal de sortie du comparateur selon la présente invention.

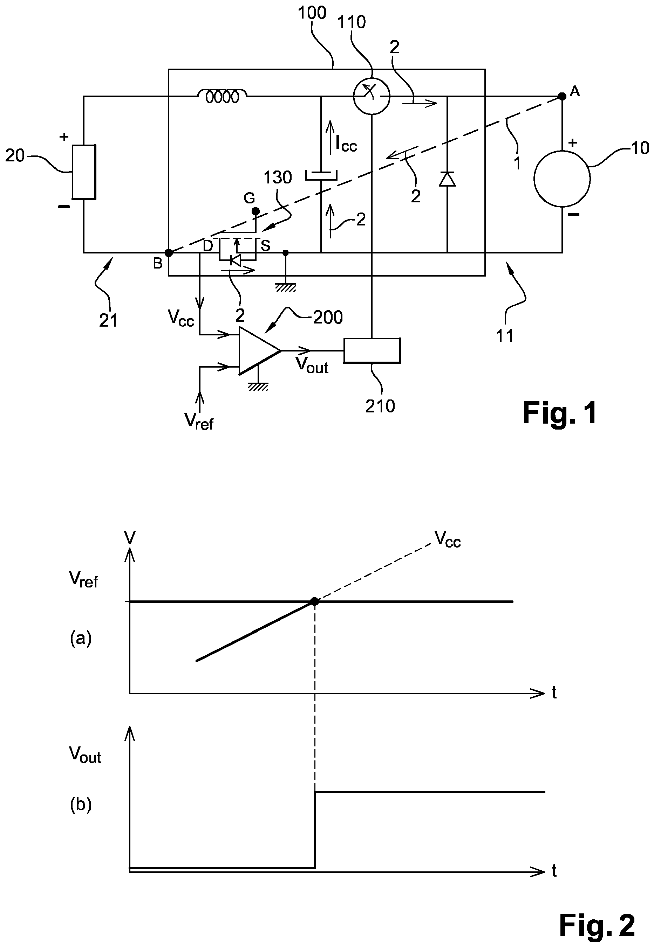

La figure 1 est un schéma d'un module d'alimentation d'un équipement électrique, notamment un moteur électrique à courant continu, mettant en oeuvre un procédé de détection de court-circuit.

La présente invention est propre à un circuit d'alimentation d'un équipement électrique 10, en particulier un moteur à courant continu tel qu'un moteur de groupe moto-ventilateur d'une installation de chauffage, ventilation et/ou climatisation d'un véhicule automobile.

Le circuit d'alimentation de la figure 1 inclut une source d'alimentation 20 délivrant un courant d'alimentation, notamment un courant continu. La source d'alimentation 20 est par exemple une batterie disposée dans le véhicule automobile. Le circuit d'alimentation de la figure 1 comporte également un module d'alimentation 100 comportant divers composants, en particulier implantés sur une carte électronique (PCB). La carte électronique est refroidie par un radiateur lui-même balayé par un flux d'air généré par le groupe moto-ventilateur commandé par le module d'alimentation 100.

Parmi les composants du module d'alimentation 100, on peut noter un interrupteur de courant 110, notamment du type PWM, apte à délivrer à l'équipement électrique 10, en particulier le moteur électrique du groupe moto-ventilateur, une tension d'alimentation. En particulier, dans le cadre de l'emploi d'un interrupteur de courant 110 du type PWM, la tension d'alimentation fournie à l'équipement électrique 10 est sous forme de signaux carrés de fréquence fixe mais de rapport cyclique variable.

Le module d'alimentation 100 comporte également un condensateur de filtrage d'entrée 120. De préférence, le condensateur de filtrage d'entrée 120 est du type électrochimique disposé en parallèle sur l'équipement électrique 10, par exemple le moteur électrique, et sur la source d'alimentation 20, notamment la batterie.

Afin de protéger le condensateur de filtrage d'entrée 120 contre une éventuelle inversion du courant d'alimentation, notamment du courant continu délivré par la batterie, liée à une inversion des pôles de la source d'alimentation 20, il est prévu dans le module d'alimentation 100 un composant de protection 130 ayant pour fonction d'interrompre le courant traversant le condensateur de filtrage d'entrée 120 dès qu'une inversion du courant d'alimentation est détectée.

Dans l'exemple de réalisation de la figure 1, le composant de protection 130 est un transistor de puissance MOSFET. Le transistor de puissance MOSFET comporte généralement trois bornes : un drain D, une source S et une grille G.

Le transistor est monté dans le module d'alimentation 100 de manière à être conducteur en régime nominal. Dans cet état, le potentiel de commande appliqué à la grille G est tel qu'une tension $V_{gs}$ entre la grille G et la source S est supérieure à une limite d'une tension de seuil de conduction $V_{gsth}$ du transistor de puissance MOSFET 130. La tension de seuil de conduction $V_{gsth}$ est définie comme étant la tension $V_{gs}$ pour laquelle une zone d'inversion apparait, c'est-à-dire une création du canal de conduction entre le drain D et la source S.

Lorsque la tension $V_{gs}$ est inférieure à la tension de seuil de conduction $V_{gsth}$, le transistor de puissance MOSFET 130 est bloqué ou non-conducteur. Dans le cas contraire, le transistor de puissance MOSFET 130 est passant, il conduit le courant entre le drain D et la source S.

Lorsqu'une inversion de batterie est détectée, la grille G est portée par une centrale de gestion, non représentée, à un potentiel pour lequel la tension $V_{gs}$ est inférieure à la tension de seuil de conduction $V_{gsth}$. Le transistor de puissance MOSFET 130 devient alors non-conducteur et coupe ainsi le courant à travers le condensateur de filtrage d'entrée 120.

Un premier faisceau de conducteurs 21 relie la source d'alimentation 20, notamment la batterie, à un connecteur, non représenté, du module d'alimentation 100. De même, un autre connecteur disposé sur le module d'alimentation 100 reçoit les conducteurs d'un deuxième faisceau de conducteurs 11 reliant l'équipement électrique 10, en particulier le moteur électrique du groupe moto-ventilateur d'une installation de chauffage, ventilation et/ou climatisation d'un véhicule automobile, au module d'alimentation 100.

Or, il peut se produire qu'un contact se produise entre les conducteurs du premier faisceau 21 et les conducteurs du deuxième faisceau 11, provoquant un court-circuit dans le module d'alimentation 100. Un tel court-circuit peut être, par exemple, celui reliant le pôle '+' de l'équipement électrique 10 au pôle '-' de la source d'alimentation 20. Ce court-circuit est représenté sur la figure 1 par la ligne pointillée 1.

Dans ce cas, le condensateur de filtrage d'entrée 120 se décharge dans le circuit. Une telle décharge est représentée par des flèches 2 sur la figure 1. Comme on l'a expliqué précédemment, le courant ainsi fourni par le condensateur filtrage d'entrée 120 peut atteindre des valeurs importantes, de l'ordre de 200 A. A de telles intensités, les composants présents sur la carte électronique du module d'alimentation 100, notamment l'interrupteur de courant 110, par exemple de type PWM, peuvent s'échauffer au point d'enflammer le matériau époxy constituant la carte électronique (PCB). Ce risque est d'autant plus important que, lorsque l'équipement électrique 10 est en particulier le moteur électrique du groupe moto-ventilateur d'une installation de chauffage, ventilation et/ou climatisation d'un véhicule automobile, le moteur électrique 10 n'est plus alimenté, le radiateur de la carte électronique n'est plus refroidi par le flux d'air produit par le groupe moto-ventilateur. Il est donc nécessaire de pouvoir détecter la situation de court-circuit le plus tôt possible afin d'en éviter les effets dommageables.

Dans ce but, il est proposé d'utiliser le composant de protection 130, en particulier le transistor de puissance MOSFET, comme moyen de détection du court-circuit du condensateur de filtrage d'entrée 120. Plus précisément, le transistor de puissance MOSFET 130 à l'état conducteur constitue un élément résistif de valeur $R_{dsON}$

permettant de mesurer un courant de décharge $I_{cc}$ à travers la résistance $R_{dsON}$ du transistor de puissance MOSFET 130. Il suffit pour cela de mesurer une tension $V_{cc}$ égale au produit de la résistance $R_{dsON}$ du transistor de puissance MOSFET 130 par la valeur d'un courant de décharge $I_{cc}$ aux bornes du transistor de puissance MOSFET 130, assurant une fonction de protection. On a donc :

$$V_{cc} = R_{dsON} \cdot I_{cc}$$

Comme l'indique la figure 1, la mesure de la tension $V_{cc}$ peut être effectuée au moyen d'un comparateur de tensions 200, à savoir de la tension $V_{cc}$ et d'une tension de référence $V_{réf}$.

La figure 2 représente en un diagramme des tensions appliquées au comparateur de tensions 200 du module d'alimentation 100 de la figure 1 (figure 2 a), et un diagramme correspondant du signal de sortie du comparateur de tensions 200 (figure 2 b) selon la présente invention.

Comme représenté sur la figure 2, lorsqu'un court-circuit se produit dans le module d'alimentation 100, la tension $V_{cc}$ dépasse une valeur de la tension de référence $V_{réf}$ indicatrice d'un court-circuit, la tension de sortie $V_{out}$ du comparateur de tensions 200 change alors d'état logique, la détection de ce changement d'état constituant la détection du court-circuit.

La tension de sortie $V_{out}$ peut être à son tour utilisée pour mettre fin à la situation de court-circuit. Pour cela, la sortie du comparateur de tensions 200 est appliquée, par exemple, à un circuit de commande 210 de l'interrupteur de courant 110, notamment de type PWM, de manière à l'amener à l'état ouvert et interrompre le courant de court-circuit dans le circuit de décharge du condensateur de filtrage d'entrée 120.

Bien entendu, la tension $V_{cc}$ aux bornes du transistor de puissance MOSFET 130 pourrait être mesurée par d'autres moyens qu'un comparateur de tensions, comme par exemple un amplificateur de tension.

Bien évidemment, l'invention n'est pas limitée aux modes de réalisation décrits précédemment et fournis uniquement à titre d'exemple et englobe d'autres variantes que pourra envisager l'homme du métier dans le cadre de la présente invention et notamment toutes combinaisons des différents modes de réalisation décrits précédemment. La présente invention est uniquement limitée par les revendications suivantes.

**Revendications**

1. Procédé de détection d'un court-circuit dans un module d'alimentation (100) d'un équipement électrique (10), en particulier à courant continu, le module d'alimentation comprenant un condensateur de filtrage d'entrée (120) disposé en parallèle sur l'équipement électrique (10), **caractérisé en ce que** le procédé consiste à détecter le courant de décharge ($I_{cc}$) fourni par le condensateur de filtrage d'entrée (120) consécutivement à un court-circuit dans le module d'alimentation (100), le courant de décharge ($I_{cc}$) étant détecté par la mesure d'une tension ($V_{cc}$) aux bornes d'un élément résistif (130) disposé sur le circuit de décharge du condensateur de filtrage d'entrée (120), l'élément résistif étant constitué par un composant de protection (130) du condensateur de filtrage d'entrée (120) contre une inversion de polarité du courant d'alimentation.

2. Procédé selon la revendication 1, dans lequel le composant de protection est un transistor de puissance MOSFET (130).

3. Module d'alimentation (100) d'un équipement électrique (10), en particulier à courant continu, le module d'alimentation comprenant un condensateur de filtrage d'entrée (120) disposé en parallèle sur l'équipement électrique (10), **caractérisé en ce que** le module d'alimentation (100) comporte des moyens de détection (130, 200) du courant de décharge ($I_{cc}$) fourni par le condensateur de filtrage d'entrée (120) consécutivement à un court-circuit dans le module d'alimentation (100), comprenant un élément résistif (130) disposé sur le circuit de décharge du condensateur de filtrage d'entrée (120), et des moyens de mesure (200) d'une tension ($V_{cc}$) aux bornes de l'élément résistif (130), l'élément résistif (130) étant constitué par un composant de protection du condensateur de filtrage d'entrée (120) contre une inversion de polarité du courant d'alimentation.

4. Module d'alimentation selon la revendication 3, dans lequel les moyens de mesure (200) de la tension ($V_{cc}$) comprennent un amplificateur de tension.

5. Module d'alimentation selon la revendication 3, dans lequel les moyens de mesure (200) de la tension ($V_{cc}$) comprennent un comparateur de tensions.

6. Module d'alimentation selon l'une des revendications 3 à 5, dans lequel le composant de protection est un transistor de puissance MOSFET (130).

## Patentansprüche

1. Verfahren zum Detektieren eines Kurzschlusses in einem Stromversorgungsmodul (100) einer elektrischen, insbesondere Gleichstrom-, Ausrüstung (10), wobei das Stromversorgungsmodul einen Eingangsfilterkondensator (120) umfasst, der parallel zu der elektrischen Ausrüstung (10) angeordnet ist, **dadurch gekennzeichnet, dass** das Verfahren daraus besteht, den Entladungsstrom ($I_{CC}$), der von dem Eingangsfilterkondensator (120) geliefert wird, nach einem Kurzschluss in dem Stromversorgungsmodul (100) zu detektieren, wobei der Entladungsstrom ($I_{CC}$) durch die Messung einer Spannung ($V_{CC}$) an den Anschlüssen eines Widerstandselements (130) detektiert wird, das in der Entladungsschaltung des Eingangsfilterkondensators (120) angeordnet ist, wobei das Widerstandselement aus einer Schutzkomponente (130) des Eingangsfilterkondensators (120) gegen eine Umpolung des Versorgungsstroms besteht.

2. Verfahren nach Anspruch 1, wobei die Schutzkomponente ein MOSFET Leistungstransistor (130) ist.

3. Stromversorgungsmodul (100) einer elektrischen, insbesondere Gleichstrom-, Ausrüstung (10), wobei das Stromversorgungsmodul einen Eingangsfilterkondensator (120) umfasst, der parallel zu der elektrischen Ausrüstung (10) angeordnet ist, **dadurch gekennzeichnet, dass** das Stromversorgungsmodul (100) Mittel (130, 200) zum Detektieren des Entladungsstroms (Icc), der von dem Eingangsfilterkondensator (120) geliefert wird, nach einem Kurzschluss in dem Stromversorgungsmodul (100), umfassend ein Widerstandselement (130), das in der Entladungsschaltung des Eingangsfilterkondensators (120) angeordnet ist, und Mittel (200) zur Messung einer Spannung ($V_{CC}$) an den Anschlüssen des Widerstandselements (130) umfasst, wobei das Widerstandselement (130) aus einer Schutzkomponente des Eingangsfilterkondensators (120) gegen eine Umpolung des Versorgungsstroms besteht.

4. Stromversorgungsmodul nach Anspruch 3, wobei die Mittel (200) zur Messung der Spannung ($V_{CC}$) einen Spannungsverstärker umfassen.

5. Stromversorgungsmodul nach Anspruch 3, wobei die Mittel (200) zur Messung der Spannung ($V_{CC}$) einen Spannungskomparator umfassen.

6. Stromversorgungsmodul nach einem der Ansprüche 3 bis 5, wobei die Schutzkomponente ein MOSFET Leistungstransistor (130) ist.

## Claims

1. Method for detecting a short circuit in a power supply module (100) of an electrical device (10), in particular a DC electrical device, the power supply module comprising an input filter capacitor (120) that is arranged in parallel with the electrical device (10), **characterized in that** the method consists in detecting the discharge current ($I_{cc}$) delivered by the input filter capacitor (120) following a short circuit in the power supply module (100), the discharge current ($I_{cc}$) being detected by measuring a voltage ($V_{cc}$) across the terminals of a resistive element (130) that is arranged in the discharge circuit of the input filter capacitor (120), the resistive element consisting of a protective component (130) for protecting the input filter capacitor (120) from a reversal in the polarity of the power supply current.

2. Method according to Claim 1, wherein the protective component is a MOSFET power transistor (130).

3. Power supply module (100) of an electrical device (10), in particular a DC electrical device, the power supply module comprising an input filter capacitor (120) that is arranged in parallel with the electrical device (10), **characterized in that** the power supply module (100) includes means (130, 200) for detecting the discharge current ($I_{cc}$) delivered by the input filter capacitor (120) following a short circuit in the power supply module (100), comprising a resistive element (130) that is arranged in the discharge circuit of the input filter capacitor (120), and means (200) for measuring a voltage ($V_{cc}$) across the terminals of the resistive element (130), the resistive element (130) consisting of a protective component for protecting the input filter capacitor (120) from a reversal in the polarity of the power supply current.

4. Power supply module according to Claim 3, wherein the means (200) for measuring the voltage ($V_{cc}$) comprise a voltage amplifier.

5. Power supply module according to Claim 3, wherein the means (200) for measuring the voltage ($V_{cc}$) comprise a voltage comparator.

6. Power supply module according to one of Claims 3 to 5, wherein the protective component is a MOSFET power transistor (130).

**Fig. 1**

**Fig. 2**

**EP 2 396 665 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2007103163 A1